# EUROPEAN PATENT SPECIFICATION

(11) **EP 4 224 174 B1**
(45) Date of publication and mention of the grant of the patent: **20.11.2024**
(21) Application number: 23150552.0
(22) Date of filing: 06.01.2023
(51) Int. Cl.: G01R 15/18, G01R 15/16, G01R 15/20, G01R 15/14, G01R 1/18

(54) **CLAMP SENSOR**
KLEMMSENSOR
CAPTEUR DE SERRAGE

(30) Priority: 07.02.2022 JP 2022017336
(43) Date of publication of application: 09.08.2023
(73) Proprietor: OMRON Corporation, Kyoto 600-8530 (JP)
(72) Inventor: ISHII, Hirotoshi, Kyoto, 600-8530 (JP); OGAWA, Tadahiko, Kyoto, 600-8530 (JP)
(74) Representative: HGF

(56) References cited:
- WO-A1-2011/030796
- JP-A- 2020 024 181
- US-A- 5 426 360
- US-B2- 7 557 563
- US-B2- 9 488 678

## Description

### Technical Field

The present invention relates to a clamp sensor that clamps a measurement object and measures a measured amount of the measurement object.

### Background Art

Conventionally, as this type of clamp sensor, for example, a clamp sensor described in Patent Literature 1 (JP 2018-13500 A) is known. Patent Literature 1 describes a structure of pivoting a pair of clamp arms (also referred to as clip pieces) having different lengths from a pivoting axis about the pivoting axis in directions approaching each other to clamp an electric wire being a measurement object between the pair of clamp arms. According to this structure, it is possible to more reliably clamp a plurality of types of electrical wires having different diameters and measure a measurement amount of the electrical wire, for example, a voltage applied to the electrical wire and a current flowing through the electrical wire.

Patent Literature 2 (WO 2011/030796 A1) describes a clamp type electromagnetic field sensor for measuring the current flowing through a conductor or the voltage applied to it.

### Citation List

### Patent Literature

Patent Literature 1: JP 2018-13500 A
Patent Literature 2: WO 2011/030796 A1

### Summary of Invention

### Technical Problem

It may be required to surround the outer periphery of the electric wire under measurement with an electromagnetic wave shield or an electrode. In this case, in the clamp sensor described in Patent Literature 1, each clamp arm is provided with an electromagnetic wave shield or an electrode. However, in the clamp sensor described in Patent Literature 1, when the diameter of the electric wire is large, the pair of clamp arms is separated from each other. Accordingly, a gap is generated between the electromagnetic wave shields or the electrodes provided in the respective clamp arms. As a result, there is a possibility that the shield performance is deteriorated due to the influence of the noise through the gap or the measurement accuracy of the electric wire through the electrode is deteriorated.

Thus, for example, it is conceivable to provide a third clamp arm for surrounding the outer periphery of the electric wire. The third clamp arm forms a cylindrical shape having an inner diameter larger than the maximum diameter of an electric wire that can be clamped by the clamp sensor by making contact with one of the pair of clamp arms. Accordingly, the outer periphery of the electric wire can be surrounded by a shield or an electrode provided on the third clamp arm and the shield or the electrode provided on one of the pair of clamp arms regardless of the diameter of the electric wire.

However, the third clamp arm is a separate member from the pair of clamp arms. Therefore, a means for preventing a contact failure between the shield or the electrode provided on the third clamp arm and the shield or the electrode provided on one of the pair of clamp arms is required. For example, it is conceivable to connect two shields or electrodes with a cable disposed outside the clamp arm. However, the cable may inhibit the motion of the clamp arm.

Therefore, an object of the present invention is to solve the above problem, and to provide a clamp sensor capable of reducing a possibility of contact failure between two conductors surrounding an outer periphery of a measurement object.

### Solution to Problem

In order to achieve the object, the present invention is configured as follows.

A clamp sensor according to an aspect of the present invention includes: a first clamp arm configured to pivot about a pivoting axis; a second clamp arm configured to pivot about the pivoting axis, the second clamp arm configured to clamp a measurement object in cooperation with the first clamp arm; a measurement unit provided on at least one of the first clamp arm and the second clamp arm, the measurement unit configured to measure a measured amount of the measurement object clamped by the first clamp arm and the second clamp arm; a first conductor provided on the first clamp arm so as to face an outer circumferential surface of the measurement object clamped by the first clamp arm and the second clamp arm, the first conductor including a first contact portion configured to come into contact with and separate from the second clamp arm; and a second conductor provided on the second clamp arm so as to face an outer circumferential surface of the measurement object clamped by the first clamp arm and the second clamp arm, the second conductor including a second contact portion configured to come into contact with and separate from the first contact portion. One of the first contact portion and the second contact portion comprises a leaf spring portion protruding in a width direction parallel to the pivoting axis and inclined with respect to the width direction so as to approach other of the first contact portion and the second contact portion. The first contact portion and the second contact portion come into contact with each other in a state where one of the first contact portion and the second contact portion is pressed by the other and the leaf spring portion is bent by elastic deformation.

### Advantageous Effects of Invention

According to the present invention, it is possible to reduce the possibility of contact failure between two conductors surrounding the outer circumference of the measurement object.

### Brief Description of Drawings

Fig. 1 is a perspective view of a clamp sensor according to an embodiment of the present invention.
Fig. 2 is an exploded perspective view of the clamp sensor according to the embodiment of the present invention.
Fig. 3 is a perspective view of the clamp sensor in which the cover member is removed from Fig. 1.
Fig. 4 is a perspective cross-sectional view of the clamp sensor according to the embodiment of the present invention.
Fig. 5 is a right side view of Fig. 4.
Fig. 6 is a perspective view of a first clamp arm.
Fig. 7 is a perspective cross-sectional view of the clamp sensor according to the embodiment of the present invention.
Fig. 8 is a perspective view of the clamp sensor according to the embodiment of the present invention.
Fig. 9 is a right side view of the clamp sensor according to the embodiment of the present invention.

### Description of Embodiments

A clamp sensor according to an aspect of the present invention includes: a first clamp arm configured to pivot about a pivoting axis; a second clamp arm configured to pivot about the pivoting axis, the second clamp arm configured to clamp a measurement object in cooperation with the first clamp arm; a measurement unit provided on at least one of the first clamp arm and the second clamp arm, the measurement unit configured to measure a measured amount of the measurement object clamped by the first clamp arm and the second clamp arm; a first conductor provided on the first clamp arm so as to face an outer circumferential surface of the measurement object clamped by the first clamp arm and the second clamp arm, the first conductor including a first contact portion configured to come into contact with and separate from the second clamp arm; and a second conductor provided on the second clamp arm so as to face an outer circumferential surface of the measurement object clamped by the first clamp arm and the second clamp arm, the second conductor including a second contact portion configured to come into contact with and separate from the first contact portion. One of the first contact portion and the second contact portion comprises a leaf spring portion protruding in a width direction parallel to the pivoting axis and inclined with respect to the width direction so as to approach other of the first contact portion and the second contact portion. The first contact portion and the second contact portion come into contact with each other in a state where one of the first contact portion and the second contact portion is pressed by the other and the leaf spring portion is bent by elastic deformation.

According to this configuration, the first contact portion of the first conductor and the second contact portion of the second conductor are not only in contact with each other, but one of the first contact portion and the second contact portion presses the other. Accordingly, between the first conductor and the second conductor, an elastic force against the counterpart acts. As a result, the contact strength between the first conductor and the second conductor increases. As a result, the possibility of contact failure between the first conductor and the second conductor can be reduced.

In the clamp sensor, the first contact portion may be positioned at a tip portion of the first clamp arm. The second contact portion may be positioned at a tip portion of the second clamp arm.

The tip portions of the first clamp arm and the second clamp arm are farther away from the pivoting axis than the base end portion. Therefore, the elastic force when the tip portions of the first clamp arm and the second clamp arm are in contact with each other can be made larger than the elastic force when the base end portions of the first clamp arm and the second clamp arm are in contact with each other. That is, according to this configuration, the elastic force acting between the first contact portion and the second contact portion can be increased. Accordingly, the contact strength between the first contact portion and the second contact portion can be increased.

In the clamp sensor, the first conductor may include a plurality of the first contact portions. The second conductor may include a plurality of the second contact portions provided on a one-by-one basis correspondingly to each of the plurality of first contact portions.

According to this configuration, even if a contact failure occurs in a part of the plurality of first contact portions and the second contact portions, the remaining first contact portions and the second contact portions are in contact with each other, so that a contact failure between the first conductor and the second conductor can be avoided.

In the clamp sensor, the first conductor may be formed by coating the first clamp arm with a conductive material. The second conductor may be formed by coating the second clamp arm with a conductive material.

According to this configuration, since it is not necessary to arrange a conductive member on the first clamp arm and the second clamp arm, the number of components included in the first clamp arm and the second clamp arm can be reduced.

In the clamp sensor, at least one of the first clamp arm and the second clamp arm may include a projection. The projection may be provided at the same position as the first contact portion and the second contact portion in an insertion direction of the measurement object into the clamp sensor when the measurement object is clamped by the first clamp arm and the second clamp arm, or at a position upstream of the first contact portion and the second contact portion in the insertion direction. The projection included in the first clamp arm may protrude more toward the second contact portion than toward the first contact portion as viewed from a width direction parallel to the pivoting axis. The projection included in the second clamp arm may protrude more toward the first contact portion than toward the second contact portion as viewed from the width direction.

According to this configuration, the projection is positioned at the same position in the insertion direction as the first contact portion and the second contact portion or upstream of the first contact portion and the second contact portion in the insertion direction. In addition, the projection protrudes larger than the first contact portion and the second contact portion. Therefore, when the measurement object is inserted along the insertion direction between the first clamp arm and the second clamp arm, the projection can inhibit the measurement object from coming into contact with the first contact portion and the second contact portion. Accordingly, it is possible to reduce the possibility that the first contact portion and the second contact portion are worn or damaged by coming into contact with the measurement object.

In the clamp sensor, the first conductor and the second conductor may have an electromagnetic wave shielding function for the measurement object clamped by the first clamp arm and the second clamp arm.

According to this configuration, the outer circumferential surface of the measurement object can be largely surrounded in the circumferential direction by the electromagnetic wave shield including the first conductor and the second conductor connected to each other. Therefore, it is possible to enhance the shielding effect against the electromagnetic wave that may affect the measurement object.

In the clamp sensor, the first conductor and the second conductor may be electrodes functioning as the measurement units.

According to this configuration, the electrodes including the first conductor and the second conductor connected to each other can largely surround the outer circumferential surface of the measurement object in the circumferential direction. Therefore, the measurement accuracy by the measurement unit can be improved.

In the clamp sensor, the first conductor may include: a first shield conductor having an electromagnetic wave shielding function for the measurement object clamped by the first clamp arm and the second clamp arm; and a first electrode functioning as the measurement unit. The second conductor may include: a second shield conductor having an electromagnetic wave shielding function for the measurement object clamped by the first clamp arm and the second clamp arm; and a second electrode functioning as the measurement unit. Each of the first shield conductor and the first electrode may include the first contact portion. Each of the second shield conductor and the second electrode may include the second contact portion. The first contact portion of the first shield conductor and the second contact portion of the second shield conductor may come into contact with each other and separate from each other. The first contact portion of the first electrode and the second contact portion of the second electrode may come into contact with each other and separate from each other.

According to this configuration, the outer circumference of the measurement object can be largely surrounded by the electromagnetic wave shield including the first contact portion and the second contact portion connected to each other. Therefore, it is possible to enhance the shielding effect against the electromagnetic wave that may affect the measurement object.

According to this configuration, the outer circumference of the measurement object can be largely surrounded by the electrodes including the first contact portion and the second contact portion connected to each other. Therefore, the measurement accuracy by the measurement unit can be improved.

In the clamp sensor, as viewed from a width direction parallel to the pivoting axis, the first contact portion of the first shield conductor and the second contact portion of the second shield conductor may be positioned on one of an opposite side from the pivoting axis with respect to a clamping position at which the measurement object is clamped by the first clamp arm and the second clamp arm and the pivoting axis side with respect to the clamping position. As viewed from the width direction, the first contact portion of the first electrode and the second contact portion of the second electrode may be positioned on the other of an opposite side from the pivoting axis with respect to the clamping position and the pivoting axis side with respect to the clamping position.

According to this configuration, the first contact portion of the first shield conductor and the second contact portion of the second shield conductor, and the first contact portion of the first electrode and the second contact portion of the second electrode are positioned on sides opposite to each other across a clamping position. Therefore, the arrangement space of the contact portion of the shield conductor and the arrangement space of the contact portion of the electrode are not reduced by the arrangement space of the counterpart.

When the distance between the shield conductor and the electrode is too small, the shielding performance and the measurement accuracy may be deteriorated. However, according to this configuration, it is easy to increase the distance between the shield conductor and the electrode. When the distance is large, it is possible to avoid deterioration of the shielding performance and the measurement accuracy.

### <Embodiment>

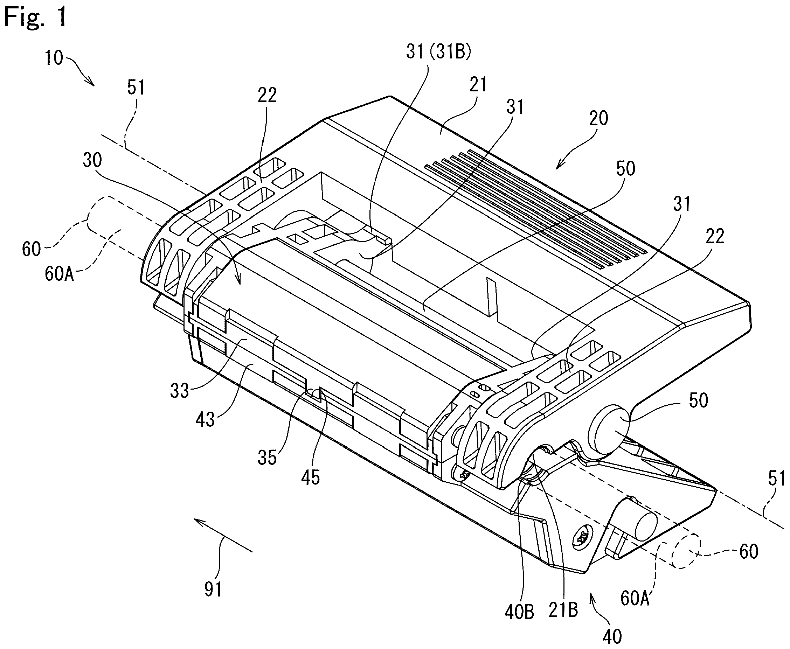

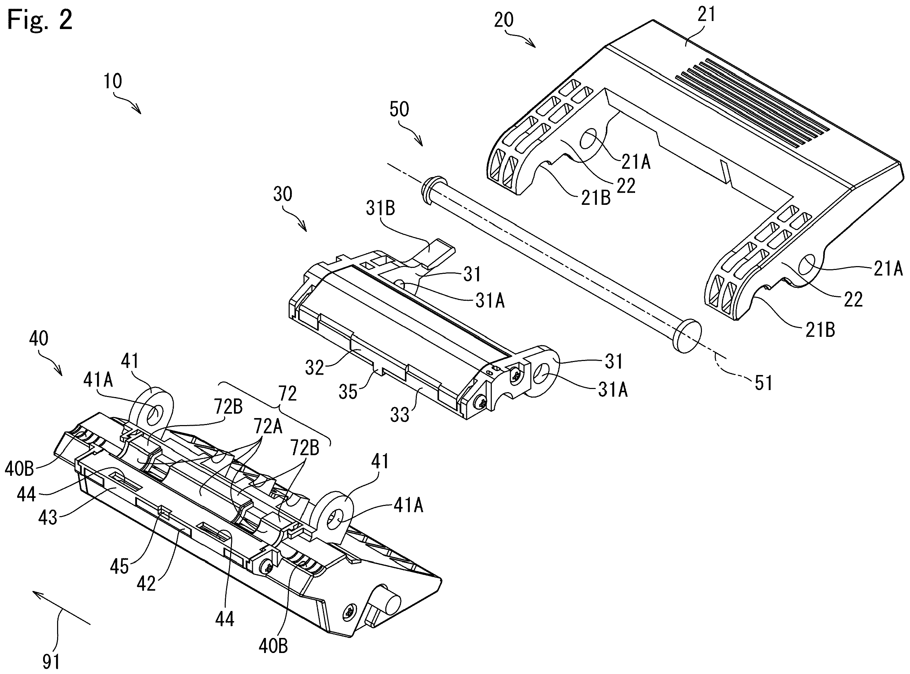

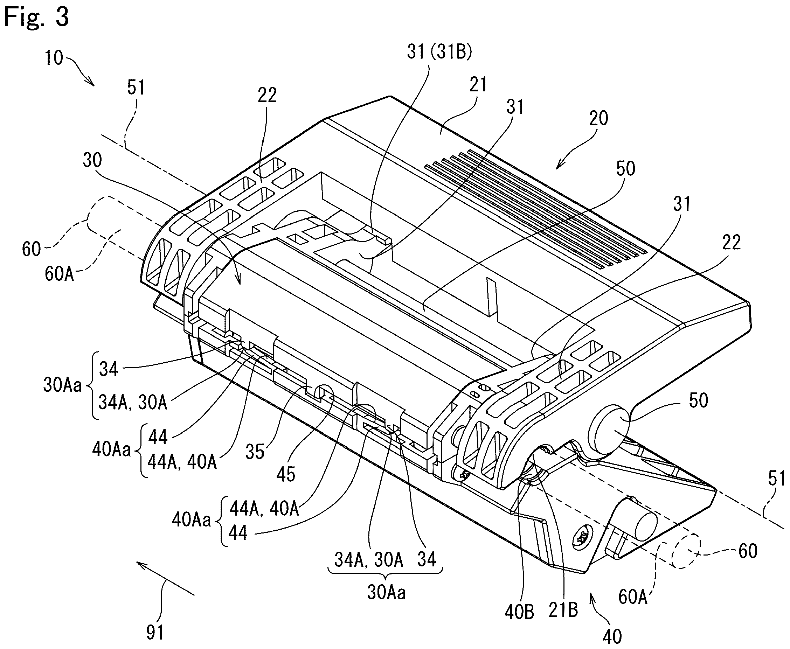

Fig. 1 is a perspective view of a clamp sensor according to an embodiment of the present invention. Fig. 2 is an exploded perspective view of the clamp sensor according to the embodiment of the present invention. Fig. 3 is a perspective view of the clamp sensor in which the cover member is removed from Fig. 1.

As shown in Figs. 1 to 3, the clamp sensor 10 according to the present embodiment includes clamp arms 20, 30, and 40 and a shaft 50. The clamp arm 30 is an example of a first clamp arm. The clamp arm 40 is an example of a second clamp arm.

The clamp arms 20 and 40 are configured to be able to clamp the measurement object 60 in cooperation with each other. The clamp arms 30 and 40 are configured to be able to clamp the measurement object 60 while covering the outer circumferential surface 60A of the measurement object 60 in cooperation with each other. In the present embodiment, the measurement object 60 is an electric wire. It should be noted that the clamp sensor 10 according to the present embodiment can clamp a plurality of types of electric wires having different diameters.

The clamp arm 20 is configured to pivot about a pivoting axis 51. In the present embodiment, the shaft 50 passes through the through hole 21A provided in the clamp arm 20. The pivoting axis 51 is an imaginary line passing through the center of the shaft 50. In the present embodiment, the clamp arm 20 is biased by a biasing member (not shown) such as a torsion coil spring so as to pivot in a direction approaching the clamp arm 40 about the pivoting axis 51.

The clamp arm 20 includes a main body portion 21 and a pair of arm portions 22 protruding from the main body portion 21. The respective arm portions 22 protrude from both end portions of the main body portion 21 in the width direction 91 parallel to the pivoting axis 51. Each arm portion 22 has the above-described through hole 21A and a pressing surface 21B. The pressing surface 21B is curved in an arc shape as viewed from the width direction 91. The curvature of the pressing surface 21B is set in accordance with the diameter of the measurement object 60 (for example, equal to or slightly larger than the diameter of the measurement object 60).

The clamp arm 30 is configured to pivot about the pivoting axis 51. In the present embodiment, the clamp arm 30 is provided between the pair of arm portions 22 of the clamp arm 20. The shaft 50 passes through the through hole 31A provided in the clamp arm 30. In the present embodiment, the clamp arm 30 is biased by a biasing member (not shown) such as a torsion coil spring so as to pivot in a direction approaching the clamp arm 40 about the pivoting axis 51.

The clamp arm 30 has a pair of protrusions 31. Each protrusion 31 has the above-described through hole 31A. One of the pair of protrusions 31 has a protruding portion 31B. The protruding portion 31B is opposed to the main body portion 21 of the clamp arm 20 in a pivoting direction (a circumferential direction around the pivoting axis 51) of the clamp arms 20, 30, and 40. When the main body portion 21 of the pivoting clamp arm 20 presses the protrusion 31, the clamp arm 30 pivots.

The clamp arm 30 includes a cover member 33, a pair of projections 34, and a projection 35.

The cover member 33 covers the projection 34. The cover member 33 is attachable to and detachable from the clamp arm 30. In Figs. 1 and 2, the cover member 33 is attached to the clamp arm 30. In Fig. 3, the cover member 33 is detached from the clamp arm 30.

The projections 34 and 35 are provided at the tip portion 32 of the clamp arm 30. The tip portion 32 of the clamp arm 30 is a portion farthest from the pivoting axis 51 in the radial direction orthogonal to the pivoting axis 51, in the clamp arm 30. The projections 34 and 35 protrude to approach the clamp arm 30 about the pivoting axis 51. The pair of projections 34 is provided at an interval in the width direction 91. The projection 35 is provided between the pair of projections 34 in the width direction 91. It should be noted that the positional relationship between the projections 34 and 35 is not limited to the above, and for example, the projection 35 may be provided outside the pair of projections 34 in the width direction 91.

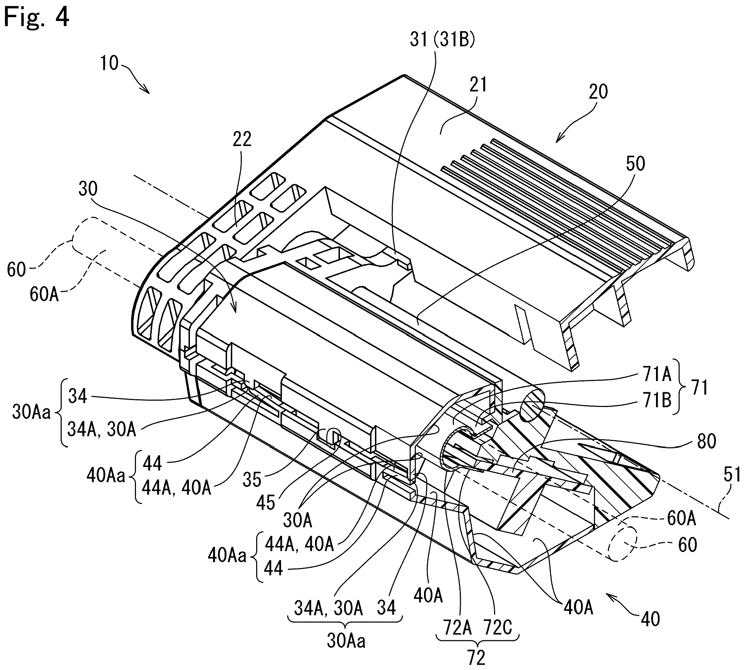

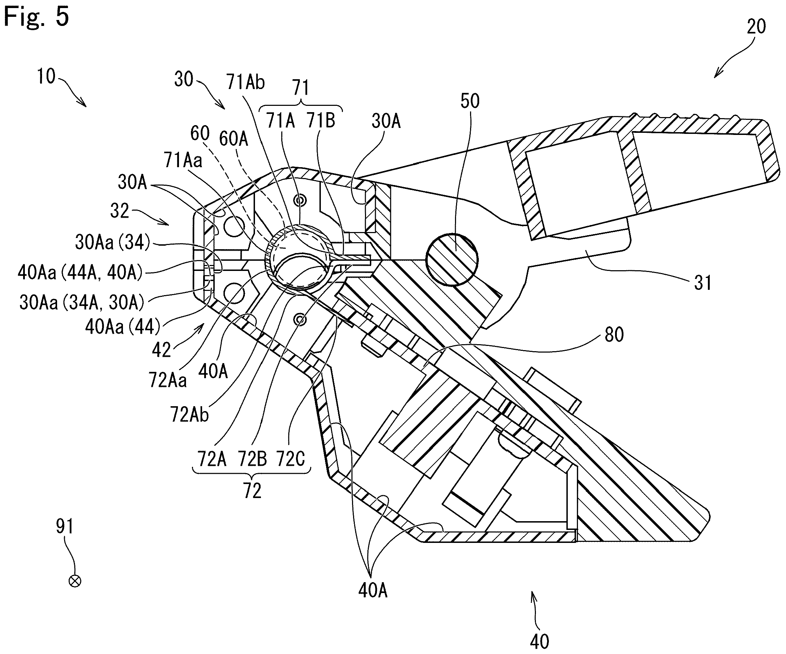

Fig. 4 is a perspective cross-sectional view of the clamp sensor according to the embodiment of the present invention. Fig. 5 is a right side view of Fig. 4.

As shown in Figs. 4 and 5, the clamp arm 30 is provided with a first shield conductor 30A and a first electrode 71. Each of the first shield conductor 30A and the first electrode 71 is an example of a first conductor.

In the present embodiment, the first shield conductor 30A is a conductive coating material (coating material containing a conductive material) applied over the inner surface of the clamp arm 30 and the tip surfaces 34A of the pair of projections 34. The first shield conductor 30A is formed so as to cover a part of the outer circumferential surface 60A of the measurement object 60 clamped by the clamp arms 20 and 40. That is, the first shield conductor 30A is provided on the clamp arm 30 so as to face the outer circumferential surface 60A of the measurement object 60 clamped between the clamp arms 20 and 40.

The conductive coating material applied to the tip surfaces 34A of the pair of projections 34 is electrically connected to the conductive coating material applied to the other portion (the conductive coating material applied to the inner surface of the clamp arm 30). The first shield conductor 30A has a first contact portion 30Aa. The first contact portion 30Aa includes the pair of projections 34 and a conductive coating material (first shield conductor 30A) applied to the tip surface 34A of each of the pair of projections 34. That is, in the present embodiment, the first shield conductor 30A includes a plurality of first contact portions 30Aa.

In the present embodiment, the first electrode 71 is a conductive plate disposed inside the clamp arm 30. The first electrode 71 includes an arc-shaped portion 71A and a protruding portion 71B.

The arc-shaped portion 71A is curved in an arc shape as viewed from the width direction 91. The curvature of the arc-shaped portion 71A is set in accordance with the diameter of the measurement object 60 (for example, equal to or slightly larger than the diameter of the measurement object 60). The arc-shaped portion 71A covers a part of the outer circumferential surface 60A of the measurement object 60. As shown in Fig. 5, in the end portion in the circumferential direction of the arc-shaped portion 71A, the one end portion 71Aa in the circumferential direction of the arc-shaped portion 71A is positioned on the opposite side of the shaft 50 (in other words, the pivoting axis 51) with respect to the clamping position of the measurement object 60. The clamping position of the measurement object 60 is a position where the measurement object 60 is clamped between the clamp arms 20 and 30 and the clamp arm 40. In the end portion in the circumferential direction of the arc-shaped portion 71A, the other end portion 71Ab in the circumferential direction of the arc-shaped portion 71A is positioned on the shaft 50 side with respect to the clamping position of the measurement object 60. That is, the other end portion 71Ab in the circumferential direction of the arc-shaped portion 71A is positioned between the clamping position of the measurement object 60 and the shaft 50. The protruding portion 71B protrudes toward the shaft 50 from the other end portion 71Ab in the circumferential direction of the arc-shaped portion 71A.

It should be noted that the first shield conductor 30A is not limited to the conductive coating material, and the first electrode 71 is not limited to the conductive plate. For example, the first shield conductor 30A may be a conductive plate disposed inside the clamp arm 30.

As shown in Figs. 1 to 3, the clamp arm 40 is configured to pivot about the pivoting axis 51. In the present embodiment, the clamp arm 40 is provided to face the clamp arms 20 and 30 in the pivoting direction of the clamp arms 20, 30, and 40. The shaft 50 passes through the through hole 41A provided in the clamp arm 40.

The clamp arm 40 has a pair of protrusions 41. Each protrusion 41 has the above-described through hole 41A. The clamp arm 40 has receiving surfaces 40B at both end portions in the width direction 91. The receiving surface 40B is curved in an arc shape as viewed from the width direction 91. The curvature of the receiving surface 40B is set in accordance with the diameter of the measurement object 60 (for example, equal to or slightly larger than the diameter of the measurement object 60). The receiving surface 40B faces the pressing surface 21B of the clamp arm 20 in the pivoting direction, and can clamp the measurement object 60 between the receiving surface 40B and the pressing surface 21B.

The clamp arm 40 includes a cover member 43, a pair of leaf spring portions 44, and a recess 45.

The cover member 43 covers the leaf spring portion 44. The cover member 43 is attachable to and detachable from the clamp arm 40. In Figs. 1 and 2, the cover member 43 is attached to the clamp arm 40. In Fig. 3, the cover member 43 is detached from the clamp arm 40.

The leaf spring portion 44 and the recess 45 are provided at the tip portion 42 of the clamp arm 40. The tip portion 42 of the clamp arm 40 is a portion farthest from the pivoting axis 51 in the radial direction orthogonal to the pivoting axis 51, in the clamp arm 40. Each of the pair of leaf spring portions 44 faces a corresponding one of the pair of projections 34 in the pivoting direction. Each of the pair of leaf spring portions 44 protrudes outward in the width direction 91 from the tip portion 42. Each of the pair of leaf spring portions 44 is inclined with respect to the width direction 91 so as to approach the projection 34 as it goes outward in the width direction 91. The leaf spring portion 44 can be bent in the pivoting direction by elastic deformation.

The recess 45 is provided between the pair of leaf spring portions 44 in the width direction 91. The recess 45 faces the projection 35 in the pivoting direction. The projection 35 can be fitted into the recess 45 (see Figs. 1 and 3).

As shown in Figs. 4 and 5, the clamp arm 40 is provided with a second shield conductor 40A and a second electrode 72. Each of the second shield conductor 40A and the second electrode 72 is an example of a second conductor.

In the present embodiment, the second shield conductor 40A is a conductive coating material applied over the inner surface of the clamp arm 40 and the opposing surfaces 44A of the pair of leaf spring portions 44. Among the surfaces of the pair of leaf spring portions 44, the opposing surfaces 44A of the pair of leaf spring portions 44 are surfaces facing the tip surface 34A of the projection 34 in the pivoting direction. The second shield conductor 40A is formed so as to cover a part of the outer circumferential surface 60A of the measurement object 60 clamped by the clamp arms 30 and 40. That is, the second shield conductor 40A is provided on the clamp arm 40 so as to face the outer circumferential surface 60A of the measurement object 60 clamped between the clamp arms 30 and 40.

The conductive coating material applied to the opposing surfaces 44A of the pair of leaf spring portions 44 is electrically connected to the conductive coating material applied to the other portion (the conductive coating material applied to the inner surface of the clamp arm 40). The second shield conductor 40A has a second contact portion 40Aa. The second contact portion 40Aa includes the pair of leaf spring portions 44 and a conductive coating material (second shield conductor 40A) applied to the opposing surface 44A of each of the pair of leaf spring portions 44. That is, in the present embodiment, the second shield conductor 40A includes the plurality of second contact portions 40Aa provided on a one-by-one basis correspondingly to each of the plurality of first contact portions 30Aa.

In the present embodiment, the second electrode 72 is a conductive plate disposed inside the clamp arm 40. The second electrode 72 includes an arc-shaped portion 72A and protruding portions 72B and 72C.

The arc-shaped portion 72A is curved in an arc shape as viewed from the width direction 91. The curvature of the arc-shaped portion 72A is set in accordance with the diameter of the measurement object 60 (for example, equal to or slightly larger than the diameter of the measurement object 60). The arc-shaped portion 72A covers a part of the outer circumferential surface 60A of the measurement object 60 from the opposite side from the arc-shaped portion 71A of the first electrode 71. That is, the second electrode 72 clamps the measurement object 60 between the second electrode 72 and the first electrode 71. As shown in Fig. 5, in the end portion in the circumferential direction of the arc-shaped portion 72A, the one end portion 72Aa in the circumferential direction of the arc-shaped portion 72A is positioned on the opposite side of the shaft 50 (in other words, the pivoting axis 51) with respect to the clamping position of the measurement object 60. In the end portion in the circumferential direction of the arc-shaped portion 72A, the other end portion in the circumferential direction of the arc-shaped portion 72A is positioned on the shaft 50 side with respect to the clamping position of the measurement object 60. That is, the other end portion in the circumferential direction of the arc-shaped portion 72A is positioned between the clamping position of the measurement object 60 and the shaft 50. The protruding portion 72B protrudes toward the shaft 50 from the other end portion in the circumferential direction of the arc-shaped portion 72A.

The protruding portion 72C is provided adjacent to the protruding portion 72B in the width direction 91. The protruding portion 72C protrudes from the other end portion in the circumferential direction of the arc-shaped portion 72A. The protruding portion 72C protrudes in a direction away from the clamp arm 30 as viewed from the width direction 91. The protruding portion 72C is electrically connected to the printed circuit board 80 disposed inside the clamp arm 40. The printed circuit board 80 is mounted with various electronic components constituting a circuit for measuring the measured amount of the measurement object 60. In the present embodiment, the measured amount is a voltage applied to the measurement object 60 (electric wire) or a current flowing through the measurement object 60 (electric wire).

It should be noted that the second shield conductor 40A is not limited to the conductive coating material, and the second electrode 72 is not limited to the conductive plate. For example, the second shield conductor 40A may be a conductive plate disposed inside the clamp arm 40.

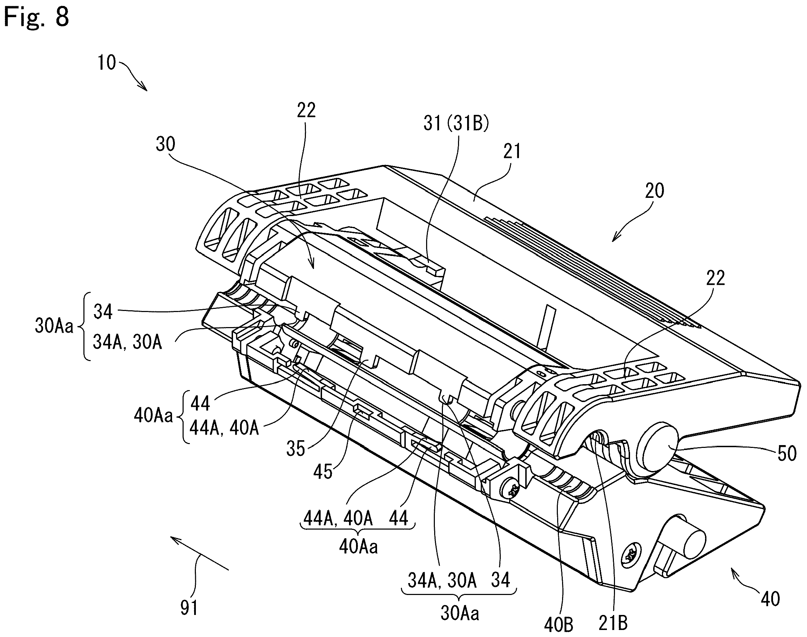

The first contact portion 30Aa and the second contact portion 40Aa can be in contact with each other (see Fig. 3) and separated from each other (see Fig. 8).

In a state where the clamp arms 20 and 30 are opened with respect to the clamp arm 40 (see Fig. 8), the first contact portion 30Aa and the second contact portion 40Aa are separated from each other.

On the other hand, as shown in Figs. 3 to 5, in a state where the clamp arms 30 and 40 clamp the measurement object 60, the first contact portion 30Aa and the second contact portion 40Aa come into contact with each other. At this time, the tip surface 34A of the projection 34 being a part of the first contact portion 30Aa presses the opposing surface 44A of the leaf spring portion 44 being a part of the second contact portion 40Aa in the pivoting direction. Accordingly, the leaf spring portion 44 is bent in the pivoting direction by elastic deformation. As a result, the first contact portion 30Aa (specifically, the first shield conductor 30A coated on the tip surface 34A of the projection 34) and the second contact portion 40Aa (specifically, the second shield conductor 40A coated on the opposing surface 44A of the leaf spring portion 44) come into contact with each other in a state where the second contact portion 40Aa is pressed by the first contact portion 30Aa and bent by elastic deformation. With the above, the first shield conductor 30A and the second shield conductor 40A are electrically connected to each other.

In the present embodiment, the second shield conductor 40A is grounded. In other words, the second shield conductor 40A is electrically connected to the ground. Therefore, the first shield conductor 30A electrically connected to the second shield conductor 40A is also grounded. Here, the first shield conductor 30A and the second shield conductor 40A face the outer circumferential surface 60A of the measurement object 60 clamped by the clamp arms 30 and 40 and surround the outer circumferential surface 60A. With the above configuration, the first shield conductor 30A and the second shield conductor 40A have an electromagnetic wave shielding function with respect to the measurement object 60 clamped by the clamp arms 30 and 40. It should be noted that the first shield conductor 30A may be grounded instead of the second shield conductor 40A, or both the first shield conductor 30A and the second shield conductor 40A may be grounded.

It should be noted that in the present embodiment, the first shield conductor 30A and the second shield conductor 40A are in contact with each other at the tip portions 32 and 42, but are not in contact with each other on the opposite side from the tip portions 32 and 42 with respect to the clamping position of the measurement object 60. However, the first shield conductor 30A and the second shield conductor 40A may be in contact with each other on the opposite side.

The first electrode 71 and the second electrode 72 shown in Figs. 4 and 5 can be in contact with each other and can be separated from each other.

In a state where the clamp arms 20 and 30 are opened with respect to the clamp arm 40 (see Fig. 8), the first electrode 71 and the second electrode 72 are separated from each other.

On the other hand, as shown in Figs. 4 and 5, in a state where the clamp arms 30 and 40 clamp the measurement object 60, the first electrode 71 and the second electrode 72 come into contact with each other. Specifically, one end portion 71Aa in the circumferential direction of the arc-shaped portion 71A of the first electrode 71 is in contact with and electrically connected to one end portion 72Aa in the circumferential direction of the arc-shaped portion 72A of the second electrode 72. In addition, the protruding portion 71B of the first electrode 71 is in contact with and electrically connected to the protruding portion 72B of the second electrode 72. Accordingly, the first electrode 71 and the second electrode 72 completely surround the measurement object 60 as viewed from the width direction 91.

In the present embodiment, the measurement object 60 is an electric wire, and the electric wire includes a conductor and a covering portion covering the conductor. The first electrode 71 and the second electrode 72 face the conductor of the electric wire across the covering portion of the electric wire. That is, the first electrode 71 and the second electrode 72 are capacitively coupled to the measurement object 60 (specifically, the conductor of the electric wire), and function as a voltage detection element configured to measure the voltage (measured amount) applied to the conductor of the electric wire clamped by the clamp arms 30 and 40 in a non-contact manner. That is, the first electrode 71 and the second electrode 72 are an example of a measurement unit and an example of an electrode functioning as a measurement unit.

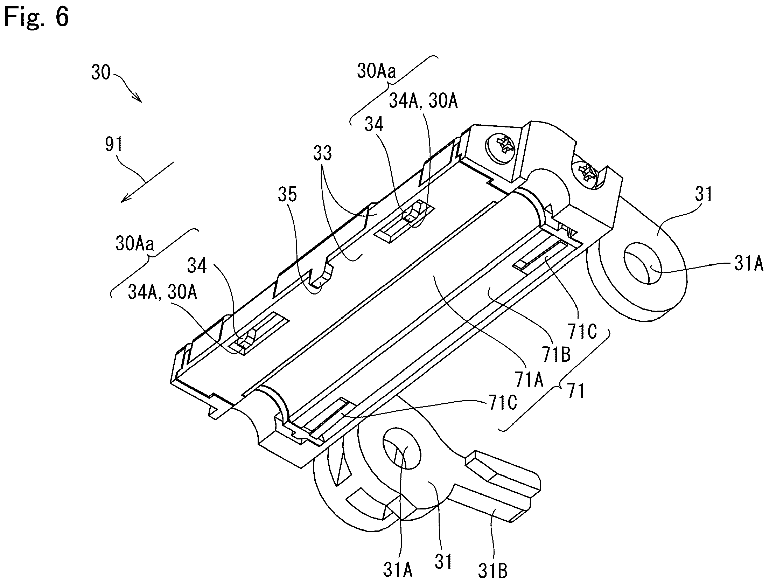

Fig. 6 is a perspective view of a first clamp arm. As shown in Fig. 6, the first electrode 71 includes a leaf spring portion 71C. The leaf spring portions 71C are provided at both end portions in the width direction 91 of the protruding portion 71B. The leaf spring portion 71C extends outward in the width direction 91 from the protruding portion 71B. The leaf spring portion 71C is inclined with respect to the width direction 91 so as to approach the protruding portion 72B of the second electrode 72 as it goes outward in the width direction 91. The leaf spring portion 71C can be bent in the pivoting direction by elastic deformation.

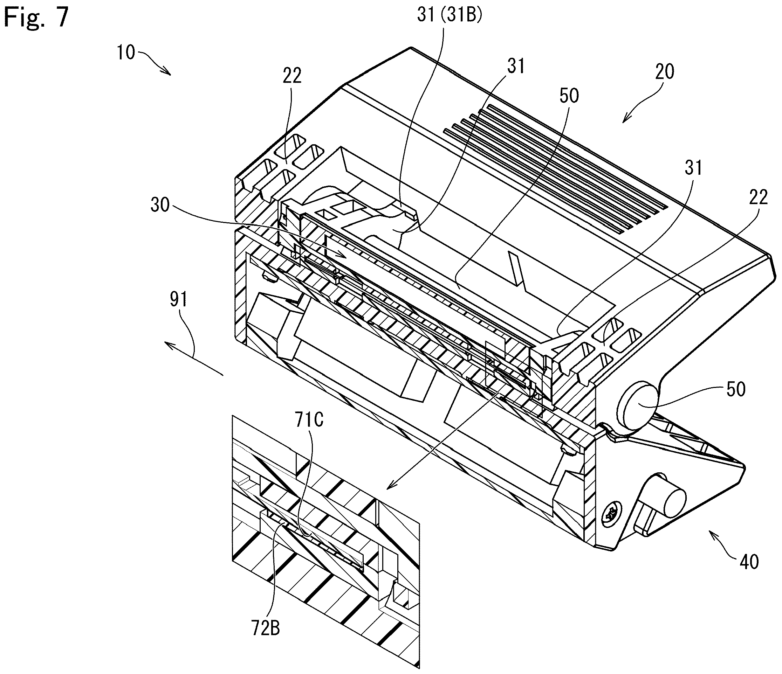

Fig. 7 is a perspective cross-sectional view of the clamp sensor according to the embodiment of the present invention. As shown in Fig. 7, each of the pair of leaf spring portions 71C of the first electrode 71 and the protruding portion 72B of the second electrode 72 can come into contact with each other. For example, in a state where the clamp arms 30 and 40 clamp the measurement object 60, each of the pair of leaf spring portions 71C and the protruding portion 72B come into contact with each other. At this time, the protruding portion 72B presses the pair of leaf spring portions 71C in the pivoting direction. Accordingly, the pair of leaf spring portions 71C is bent in the pivoting direction by elastic deformation. As a result, the protruding portion 72B and the pair of leaf spring portions 71C come into contact with each other in a state where the pair of leaf spring portions 71C is pressed by the protruding portion 72B and is bent by elastic deformation. With the above, the first electrode 71 and the second electrode 72 are electrically connected to each other. The pair of leaf spring portions 71C is an example of the first contact portion, and the protruding portion 72B is an example of the second contact portion.

The first electrode 71 and the second electrode 72 are in contact with each other on both sides of the clamping position of the measurement object 60. Accordingly, as described above, the first electrode 71 and the second electrode 72 completely surround the measurement object 60 as viewed from the width direction 91. Here, by increasing the contact pressure (in other words, the contact pressure of the one end portion 71Aa and the one end portion 72Aa) on the opposite side of the shaft 50 (pivoting axis 51) with respect to the clamping position of the measurement object 60, the reliability of the contact of the one end portions 71Aa and 72Aa is improved. However, in this case, with respect to the clamping position of the measurement object 60, the contact pressure on the shaft 50 side (in other words, the contact pressure of the protruding portion 71B and the protruding portion 72B) becomes low, and the reliability of the contact of the protruding portions 71B and 72B may decrease. However, in the present embodiment, even if the reliability of contact of the protruding portions 71B and 72B decreases, the reliability of contact between the leaf spring portion 71C and the protruding portion 72B can be favorably maintained.

As described above, as viewed from the width direction 91, the first contact portion 30Aa of the first shield conductor 30A and the second contact portion 40Aa of the second shield conductor 40A are positioned on the opposite side from the shaft 50 (the pivoting axis 51) with respect to the clamping position of the measurement object 60 as shown in Fig. 5. On the other hand, as viewed from the width direction 91, the pair of leaf spring portions 71C corresponding to the first contact portion of the first electrode 71 and the protruding portion 72B corresponding to the second contact portion of the second electrode 72 are positioned on the shaft 50 side with respect to the clamping position of the measurement object 60 as shown in Figs. 6 and 7. That is, the first contact portion 30Aa of the first shield conductor 30A and the second contact portion 40Aa of the second shield conductor 40A, and the first contact portion of the first electrode 71 and the second contact portion of the second electrode 72 are positioned on the sides opposite to each other across the clamping position of the measurement object 60.

It should be noted that in contrast to the above, as. viewed from the width direction 91, the first contact portion 30Aa of the first shield conductor 30A and the second contact portion 40Aa of the second shield conductor 40A may be positioned on the shaft 50 side with respect to the clamping position of the measurement object 60. In addition, as viewed from the width direction 91, the pair of leaf spring portions 71C of the first electrode 71 and the protruding portion 72B of the second electrode 72 may be positioned on the opposite side from the shaft 50 with respect to the clamping position of the measurement object 60.

In addition, both the first contact portion 30Aa of the first shield conductor 30A and the second contact portion 40Aa of the second shield conductor 40A, and the first contact portion of the first electrode 71 and the second contact portion of the second electrode 72 may be positioned on the same side with respect to the clamping position of the measurement object 60 (for example, both are on the opposite side from the shaft 50 with respect to the clamping position of the measurement object 60).

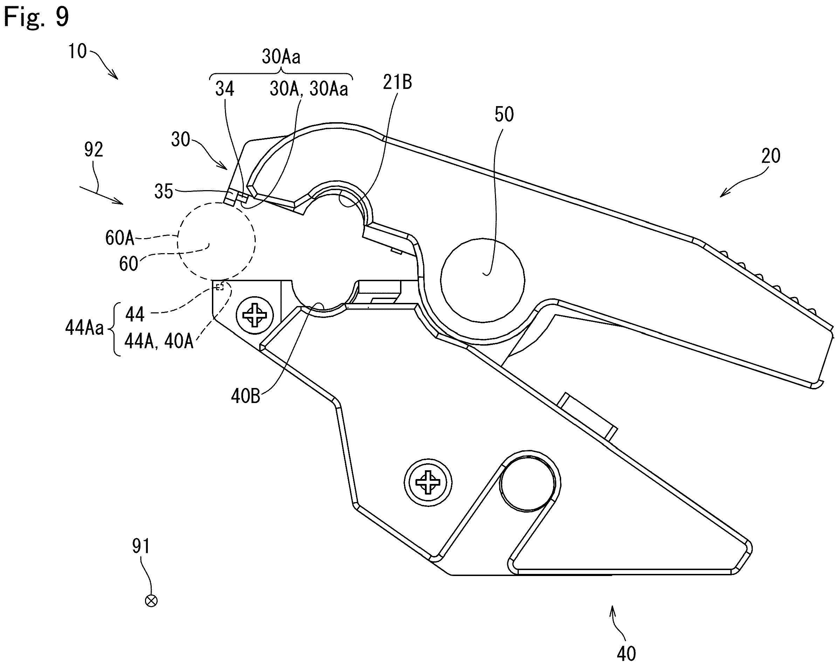

Fig. 8 is a perspective view of the clamp sensor according to the embodiment of the present invention. Fig. 9 is a right side view of the clamp sensor according to the embodiment of the present invention.

As shown in Fig. 9, the projection 35 is provided at a position upstream of the first contact portion 30Aa and the second contact portion 40Aa in the insertion direction 92, in the insertion direction 92 of the measurement object 60 into the clamp sensor 10 when the measurement object 60 is clamped by the clamp arms 30 and 40.

As shown in Figs. 8 and 9, the projection 35 included in the clamp arm 30 protrudes more to the second contact portion 40Aa side than to the first contact portion 30Aa as viewed from the width direction 91.

It should be noted that the projection 35 may be provided at the same position as the first contact portion 30Aa and the second contact portion 40Aa in the insertion direction 92. In addition, the projection 35 may be provided on the clamp arm 40. In this case, the projection 35 protrudes more to the first contact portion 30Aa side than to the second contact portion 40Aa as viewed from the width direction 91.

According to the present embodiment, the first contact portion 30Aa and the second contact portion 40Aa are not only in contact with each other, but one of the first contact portion and the second contact portion presses the other. Accordingly, between the first shield conductor 30A and the second shield conductor 40A, an elastic force against the counterpart acts. As a result, the contact strength between the first shield conductor 30A and the second shield conductor 40A increases. As a result, the possibility of contact failure between the first shield conductor 30A and the second shield conductor 40A can be reduced.

According to the present embodiment, the pair of leaf spring portions 71C and the protruding portion 72B are not only in contact with each other, but one of the first contact portion and the second contact portion presses the other. Accordingly, between the first electrode 71 and the second electrode 72, an elastic force against the counterpart acts. As a result, the contact strength between the first electrode 71 and the second electrode 72 increases. As a result, the possibility of contact failure between the first electrode 71 and the second electrode 72 can be reduced.

The tip portion 32 of the clamp arm 30 and the tip portion 42 of the clamp arm 40 are farther away from the pivoting axis 51 than the base end portion (the end portion of the pivoting axis side 51). Therefore, the elastic force when the tip portions 32 and 42 of the clamp arms 30 and 40 are in contact with each other can be made larger than the elastic force when the base end portions of the clamp arms 30 and 40 are in contact with each other. That is, according to the present embodiment, the elastic force acting between the first contact portion 30Aa and the second contact portion 40Aa can be increased. Accordingly, the contact strength between the first contact portion 30Aa and the second contact portion 40Aa can be increased.

According to the present embodiment, the clamp sensor 10 has two sets of the projections 34 and the leaf spring portions 44. Even if a contact failure occurs between the conductive paints painted on each of the projections 34 and the leaf spring portions 44 of one of the two sets, the other projections 34 and the leaf spring portions 44 of the two sets are in contact with each other, so that a contact failure between the first shield conductor 30A and the second shield conductor 40A can be avoided.

According to the present embodiment, the first shield conductor 30A and the second shield conductor 40A are conductive coating material. Therefore, since it is not necessary to arrange a conductive member on the clamp arms 30 and 40, the number of components included in the clamp arms 30 and 40 can be reduced.

According to the present embodiment, the projection 35 is positioned upstream of the pair of projections 34 in the insertion direction 92. In addition, the projection 35 protrudes larger than the pair of projections 34. Therefore, when the measurement object 60 is inserted along the insertion direction 92 between the clamp arms 30 and 40, the projection 35 can inhibit the measurement object 60 from coming into contact with the pair of projections 34. For example, as shown in Figure 9, the measurement object 60 to be inserted contacts with the projection 35 but not the projection 34. Accordingly, it is possible to reduce the possibility that the pair of projections 34 are worn or damaged by coming into contact with the measurement object 60.

According to the present embodiment, the outer circumferential surface 60A of the measurement object 60 can be largely surrounded in the circumferential direction by the electromagnetic wave shield including the first shield conductor 30A and the second shield conductor 40A connected to each other. Therefore, it is possible to enhance the shielding effect against the electromagnetic wave that may affect the measurement object 60.

According to the present embodiment, the first electrode 71 and the second electrode 72 connected to each other can largely surround the outer circumferential surface 60A of the measurement object 60 in the circumferential direction. Therefore, the measurement accuracy by the first electrode 71 and the second electrode 72 can be improved.

In the present embodiment, the measurement units (the first electrode 71 and the second electrode 72) are provided in both the clamp arms 30 and 40. However, the measurement units may be provided only on one of the clamp arms 30 and 40. For example, the clamp sensor 10 may include only one of the first electrode 71 and the second electrode 72.

In the present embodiment, the first shield conductor 30A and the second shield conductor 40A include a first contact portion 30Aa and a second contact portion 40Aa, and the first electrode 71 and the second electrode 72 include a first contact portion (a pair of leaf spring portions 71C) and a second contact portion (a protruding portion 72B). However, the first contact portion and the second contact portion may be provided on only one of the first shield conductor 30A and second shield conductor 40A and the first electrode 71 and second electrode 72. For example, the first electrode 71 and the second electrode 72 do not need to include the pair of leaf spring portions 71C corresponding to the first contact portion.

In contrast to the present embodiment, the projection 34 may be provided on the clamp arm 40, and the pair of leaf spring portions 44 may be provided on the clamp arm 30.

In the present embodiment, the first electrode 71 includes the pair of leaf spring portions 71C, but the second electrode 72 may include the pair of leaf spring portions 71C. In this case, the protruding portion 71B presses the pair of leaf spring portions 71C in the pivoting direction.

The configurations of the first contact portion and the second contact portion are not limited to the configuration described in the present embodiment. That is, as long as one of the first contact portion and the second contact portion is pressed by the other, and the first contact portion and the second contact portion are in contact with each other in a state where at least one of the one and the other is bent by elastic deformation, various configurations are applicable as the first contact portion and the second contact portion.

For example, in the present embodiment, the first contact portion 30Aa and the second contact portion 40Aa come into contact with each other in a state where the second contact portion 40Aa is pressed by the first contact portion 30Aa and the second contact portion 40Aa is bent by elastic deformation. However, in contrast to the above, the first contact portion and the second contact portion may come into contact with each other in a state where the first contact portion is pressed by the second contact portion and the first contact portion is bent by elastic deformation. In addition, the first contact portion and the second contact portion may be in contact with each other in a state where both the first contact portion and the second contact portion are pressed against each other and are bent by elastic deformation.

The present invention has been sufficiently described in connection with the preferable embodiment with reference to the drawings as appropriate, but various modifications and corrections are apparent for those skilled in the art. It should be understood that as long as such modifications and corrections do not depart from the scope of the present invention by the attached claims, they are included therein.

### Industrial Applicability

Since the clamp sensor according to the present invention can reduce the possibility of contact failure between the two conductors surrounding the outer circumference of the measurement object, the clamp sensor is useful, for example, for applications such as power quality monitoring in which voltage measurement of the measurement object needs to be accurately performed.

### Reference Signs List

10 a clamp sensor;
30 a clamp arm (a first clamp arm);
30A a first shield conductor (a first conductor);
30Aa a first contact portion;
32 a tip portion;
35 a projection;
40 a clamp arm (a second clamp arm);
40A a second shield conductor (a second conductor);
40Aa a second contact portion;
42 a tip portion;
51 a pivoting axis;
60 a measurement object;
60A a outer circumferential surface;
71 a first electrode (a measurement unit, a first conductor, a electrode);
71C a leaf spring portion (a first contact portion);
72 a second electrode (a measurement unit, a second conductor, a electrode);
72B a protruding portion (a second contact portion);
91 a width direction;
92 a insertion direction

## Claims

1. A clamp sensor (10) comprising:
a first clamp arm (30) configured to pivot about a pivoting axis (51);
a second clamp arm (40) configured to pivot about the pivoting axis (51), the second clamp arm (40) configured to clamp a measurement object (60) in cooperation with the first clamp arm (30);
a measurement unit provided on at least one of the first clamp arm (30) and the second clamp arm(40), the measurement unit configured to measure a measured amount of the measurement object (60) clamped by the first clamp arm (30) and the second clamp arm (40);
a first conductor (71) provided on the first clamp arm (30) so as to face an outer circumferential surface of the measurement object (60) clamped by the first clamp arm (30) and the second clamp arm (40), the first conductor (71) including a first contact portion (71C) configured to come into contact with and separate from the second clamp arm (40); and
a second conductor (72) provided on the second clamp arm (40) so as to face an outer circumferential surface of the measurement object (60) clamped by the first clamp arm (30) and the second clamp arm (40), the second conductor (72) including a second contact portion (72B) configured to come into contact with and separate from the first contact portion (71C), wherein
one of the first contact portion (71C) and the second contact portion (72B) comprises a leaf spring portion protruding in a width direction (91) parallel to the pivoting axis (51) and inclined with respect to the width direction (91) so as to approach other of the first contact portion (71C) and the second contact portion (72B), and wherein
the first contact portion (71C) and the second contact portion (72B) come into contact with each other in a state where one of the first contact portion (71C) and the second contact portion (72B) is pressed by the other and the leaf spring portion is bent by elastic deformation.

2. The clamp sensor (10) of claim 1, wherein
the first contact portion (71C) is positioned at a tip portion of the first clamp arm (30), and wherein
the second contact portion (72B) is positioned at a tip portion of the second clamp arm (40).

3. The clamp sensor (10) of claim 1 or 2, wherein
the first conductor (71) includes a plurality of the first contact portions, and wherein
the second conductor (72) includes a plurality of the second contact portions provided on a one-by-one basis correspondingly to each of the plurality of first contact portions.

4. The clamp sensor (10) of any one of claims 1 to 3, wherein
the first conductor (71) is formed by coating the first clamp arm (30) with a conductive material, and wherein
the second conductor (72) is formed by coating the second clamp arm (40) with a conductive material.

5. The clamp sensor (10) of any one of claims 1 to 4, wherein
at least one of the first clamp arm (30) and the second clamp arm (40) include a projection (35), wherein
the projection (35) is provided at the same position as the first contact portion (71C) and the second contact portion (72B) in an insertion direction (92) of the measurement object (60) into the clamp sensor (10) when the measurement object (60) is clamped by the first clamp arm (30) and the second clamp arm (40), or at a position upstream of the first contact portion (71C) and the second contact portion (72B) in the insertion direction (92), wherein
the projection (35) included in the first clamp arm (30) protrudes more toward the second contact portion (72B) than toward the first contact portion (71C) as viewed from a width direction (91) parallel to the pivoting axis (51), and wherein
the projection (35) included in the second clamp arm (40) protrudes more toward the first contact portion (71C) than toward the second contact portion (72B) as viewed from the width direction (91).

6. The clamp sensor (10) of any one of claims 1 to 5, wherein
the first conductor (71) and the second conductor (72) have an electromagnetic wave shielding function for the measurement object (60) clamped by the first clamp arm (30) and the second clamp arm (40).

7. The clamp sensor (10) of any one of claims 1 to 5, wherein
the first conductor (71) and the second conductor (72) are electrodes functioning as the measurement units.

8. The clamp sensor (10) of any one of claims 1 to 5, wherein
the first conductor (71) includes:
a first shield conductor (30A) having an electromagnetic wave shielding function for the measurement object (60) clamped by the first clamp arm (30) and the second clamp arm (40); and
a first electrode functioning as the measurement unit, wherein
the second conductor (72) includes:
a second shield conductor (40A) having an electromagnetic wave shielding function for the measurement object (60) clamped by the first clamp arm (30) and the second clamp arm (40); and
a second electrode functioning as the measurement unit, wherein
each of the first shield conductor (30A) and the first electrode includes the first contact portion (71C), wherein
each of the second shield conductor (40A) and the second electrode includes the second contact portion (72B), wherein
the first contact portion (71C) of the first shield conductor (30A) and the second contact portion (72B) of the second shield conductor (40A) come into contact with each other and separate from each other, and wherein
the first contact portion (71C) of the first electrode and the second contact portion (72B) of the second electrode come into contact with each other and separate from each other.

9. The clamp sensor (10) of claim 8, wherein
as viewed from a width direction (91) parallel to the pivoting axis (51), the first contact portion (71C) of the first shield conductor (30A) and the second contact portion (72B) of the second shield conductor (40A) are positioned on one of an opposite side from the pivoting axis (51) with respect to a clamping position at which the measurement object (60) is clamped by the first clamp arm (30) and the second clamp arm (40) and the pivoting axis (51) side with respect to the clamping position, and wherein
as viewed from the width direction (91), the first contact portion (71C) of the first electrode and the second contact portion (72B) of the second electrode are positioned on the other of an opposite side from the pivoting axis (51) with respect to the clamping position and the pivoting axis (51) side with respect to the clamping position.

## Patentansprüche

1. Klemmsensor (10), umfassend:
einen ersten Klemmarm (30), der konfiguriert ist, um um eine Schwenkachse (51) zu schwenken;
einen zweiten Klemmarm (40), der konfiguriert ist, um um die Schwenkachse (51) zu schwenken, wobei der zweite Klemmarm (40) konfiguriert ist, um zusammenwirkend mit dem ersten Klemmarm (30) ein Messobjekt (60) einzuklemmen;
eine Messeinheit, die an mindestens einem von dem ersten Klemmarm (30) und dem zweiten Klemmarm (40) bereitgestellt ist, wobei die Messeinheit konfiguriert ist, um eine gemessene Menge des Messobjekts (60) zu messen, das von dem ersten Klemmarm (30) und dem zweiten Klemmarm (40) eingeklemmt wird;
einen ersten Leiter (71), der an dem ersten Klemmarm (30) bereitgestellt ist, um einer äußeren Umfangsfläche des Messobjekts (60) zugewandt zu sein, das durch den ersten Klemmarm (30) und den zweiten Klemmarm (40) eingeklemmt ist, wobei der erste Leiter (71) einen ersten Kontaktabschnitt (71C) beinhaltet, der konfiguriert ist, um mit dem zweiten Klemmarm (40) in Kontakt zu kommen und davon getrennt zu werden; und
einen zweiten Leiter (72), der an dem zweiten Klemmarm (40) bereitgestellt ist, um einer äußeren Umfangsfläche des Messobjekts (60) zugewandt zu sein, das durch den ersten Klemmarm (30) und den zweiten Klemmarm (40) eingeklemmt ist, wobei der zweite Leiter (72) einen zweiten Kontaktabschnitt (72B) beinhaltet, der konfiguriert ist, um mit dem ersten Kontaktabschnitt (71C) in Kontakt zu kommen und davon getrennt zu werden, wobei
einer von dem ersten Kontaktabschnitt (71C) und dem zweiten Kontaktabschnitt (72B) einen Blattfederabschnitt umfasst, der in eine Breitenrichtung (91) parallel zu der Schwenkachse (51) hervorsteht und in Bezug auf die Breitenrichtung (91) geneigt ist, um sich dem anderen von dem ersten Kontaktabschnitt (71C) und dem zweiten Kontaktabschnitt (72B) zu nähern, und wobei
der erste Kontaktabschnitt (71C) und der zweite Kontaktabschnitt (72B) in einem Zustand miteinander in Kontakt kommen, in dem entweder der erste Kontaktabschnitt (71C) oder der zweite Kontaktabschnitt (72B) durch den jeweils anderen gedrückt wird und der Blattfederabschnitt durch elastische Verformung gebogen wird.

2. Klemmsensor (10) nach Anspruch 1, wobei
der erste Kontaktabschnitt (71C) an einem Spitzenabschnitt des ersten Klemmarms (30) positioniert ist, und wobei
der zweite Kontaktabschnitt (72B) an einem Spitzenabschnitt des zweiten Klemmarms (40) positioniert ist.

3. Klemmsensor (10) nach Anspruch 1 oder 2, wobei
der erste Leiter (71) eine Vielzahl von ersten Kontaktabschnitten beinhaltet, und wobei
der zweite Leiter (72) eine Vielzahl von zweiten Kontaktabschnitten beinhaltet, die einzeln entsprechend jedem der Vielzahl von ersten Kontaktabschnitten bereitgestellt sind.

4. Klemmsensor (10) nach einem der Ansprüche 1 bis 3, wobei
der erste Leiter (71) durch Beschichten des ersten Klemmarms (30) mit einem leitenden Material gebildet ist, und wobei
der zweite Leiter (72) durch Beschichtung des zweiten Klemmarms (40) mit einem leitenden Material gebildet ist.

5. Klemmsensor (10) nach einem der Ansprüche 1 bis 4, wobei
mindestens einer von dem ersten Klemmarm (30) und dem zweiten Klemmarm (40) einen Vorsprung (35) beinhaltet, wobei
der Vorsprung (35) in einer Einführrichtung (92) des Messobjekts (60) in den Klemmsensor (10) an der gleichen Position wie der erste Kontaktabschnitt (71C) und der zweite Kontaktabschnitt (72B) bereitgestellt ist, wenn das Messobjekt (60) durch den ersten Klemmarm (30) und den zweiten Klemmarm (40) geklemmt wird, oder an einer Position stromaufwärts von dem ersten Kontaktabschnitt (71C) und dem zweiten Kontaktabschnitt (72B) in der Einführrichtung (92), wobei
der Vorsprung (35), der in dem ersten Klemmarm (30) beinhaltet ist, gesehen von einer Breitenrichtung (91) parallel zu der Schwenkachse (51) mehr in Richtung des zweiten Kontaktabschnitts (72B) als in Richtung des ersten Kontaktabschnitts (71C) hervorsteht, und wobei
der Vorsprung (35), der in dem zweiten Klemmarm (40) beinhaltet ist, gesehen von der Breitenrichtung (91) mehr in Richtung des ersten Kontaktabschnitts (71C) als in Richtung des zweiten Kontaktabschnitts (72B) hervorsteht.

6. Klemmsensor (10) nach einem der Ansprüche 1 bis 5, wobei
der erste Leiter (71) und der zweite Leiter (72) eine Abschirmungsfunktion elektromagnetischer Wellen für das Messobjekt (60) aufweisen, das durch den ersten Klemmarm (30) und den zweiten Klemmarm (40) eingeklemmt ist.

7. Klemmsensor (10) nach einem der Ansprüche 1 bis 5, wobei
der erste Leiter (71) und der zweite Leiter (72) Elektroden sind, die als Messeinheiten funktionieren.

8. Klemmsensor (10) nach einem der Ansprüche 1 bis 5, wobei
der erste Leiter (71) Folgendes beinhaltet:
einen ersten Abschirmungsleiter (30A), der eine Abschirmungsfunktion elektromagnetischer Wellen für das Messobjekt (60) aufweist, das durch den ersten Klemmarm (30) und den zweiten Klemmarm (40) eingeklemmt ist; und
eine erste Elektrode, die als Messeinheit funktioniert, wobei
der zweite Leiter (72) Folgendes beinhaltet:
einen zweiten Abschirmungsleiter (40A), der eine Abschirmungsfunktion elektromagnetischer Wellen für das Messobjekt (60) aufweist, das durch den ersten Klemmarm (30) und den zweiten Klemmarm (40) eingeklemmt ist; und
eine zweite Elektrode, die als Messeinheit funktioniert, wobei
jeder von dem ersten Abschirmungsleiter (30A) und der ersten Elektrode den ersten Kontaktabschnitt (71C) beinhaltet, wobei
jeder von dem zweiten Abschirmungsleiter (40A) und der zweiten Elektrode den zweiten Kontaktabschnitt (72B) beinhaltet, wobei
der erste Kontaktabschnitt (71C) des ersten Abschirmungsleiters (30A) und der zweite Kontaktabschnitt (72B) des zweiten Abschirmungsleiters (40A) miteinander in Kontakt kommen und sich voneinander trennen, und wobei
der erste Kontaktabschnitt (71C) der ersten Elektrode und der zweite Kontaktabschnitt (72B) der zweiten Elektrode miteinander in Kontakt kommen und sich voneinander trennen.

9. Klemmsensor (10) nach Anspruch 8, wobei
der erste Kontaktabschnitt (71C) des ersten Abschirmungsleiters (30A) und der zweite Kontaktabschnitt (72B) des zweiten Abschirmungsleiters (40A) gesehen aus einer Breitenrichtung (91) parallel zu der Schwenkachse (51) auf einer von einer gegenüberliegenden Seite der Schwenkachse (51) in Bezug auf eine Klemmposition, an der das Messobjekt (60) durch den ersten Klemmarm (30) und den zweiten Klemmarm (40) eingeklemmt wird, und der Seite der Schwenkachse (51) in Bezug auf die Klemmposition positioniert sind, und wobei
der erste Kontaktabschnitt (71C) der ersten Elektrode und der zweite Kontaktabschnitt (72B) der zweiten Elektrode, gesehen aus der Breitenrichtung (91) auf der anderen von einer gegenüberliegenden Seite der Schwenkachse (51) in Bezug auf die Klemmposition und der Seite der Schwenkachse (51) in Bezug auf die Klemmposition positioniert sind.

## Revendications

1. Capteur de serrage (10) comprenant :
un premier bras de serrage (30) conçu pour pivoter autour d'un axe de pivotement (51) ;
un second bras de serrage (40) conçu pour pivoter autour de l'axe de pivotement (51), le second bras de serrage (40) étant conçu pour serrer un objet de mesure (60) en coopération avec le premier bras de serrage (30) ;
une unité de mesure disposée sur au moins l'un du premier bras de serrage (30) et du second bras de serrage (40), l'unité de mesure étant conçue pour mesurer une quantité mesurée de l'objet de mesure (60) serré par le premier bras de serrage (30) et le second bras de serrage (40) ;
un premier conducteur (71) disposé sur le premier bras de serrage (30) de façon à faire face à une surface circonférentielle externe de l'objet de mesure (60) serré par le premier bras de serrage (30) et le second bras de serrage (40), le premier conducteur (71) comprenant une première partie de contact (71C) conçue pour entrer en contact avec le second bras de serrage (40) et se séparer de celui-ci ; et
un second conducteur (72) disposé sur le second bras de serrage (40) de façon à faire face à une surface circonférentielle externe de l'objet de mesure (60) serré par le premier bras de serrage (30) et le second bras de serrage (40), le second conducteur (72) comprenant une seconde partie de contact (72B) conçue pour entrer en contact avec la première partie de contact (71C) et se séparer de celle-ci,
l'une de la première partie de contact (71C) et de la seconde partie de contact (72B) comprenant une partie de ressort à lame faisant saillie dans une direction de largeur (91) parallèle à l'axe de pivotement (51) et inclinée par rapport à la direction de largeur (91) de façon à se rapprocher de l'autre de la première partie de contact (71C) et de la seconde partie de contact (72B), et
ladite première partie de contact (71C) et ladite seconde partie de contact (72B) entrant en contact l'une avec l'autre dans un état où l'une de la première partie de contact (71C) et de la seconde partie de contact (72B) est pressée par l'autre et ladite partie ressort à lame étant pliée par déformation élastique.

2. Capteur de serrage (10) de la revendication 1,
ladite première partie de contact (71C) étant positionnée au niveau d'une partie pointe du premier bras de serrage (30), et
ladite seconde partie de contact (72B) étant positionnée au niveau d'une partie pointe du second bras de serrage (40).

3. Capteur de serrage (10) de la revendication 1 ou 2,
ledit premier conducteur (71) comprenant une pluralité de premières parties de contact, et
ledit second conducteur (72) comprenant une pluralité de secondes parties de contact fournies, en correspondance une par une, à chacune de la pluralité de premières parties de contact.

4. Capteur de serrage (10) de l'une quelconque des revendications 1 à 3,
ledit premier conducteur (71) étant formé en revêtant le premier bras de serrage (30) avec un matériau conducteur, et
ledit second conducteur (72) étant formé en revêtant le second bras de serrage (40) d'un matériau conducteur.

5. Capteur de serrage (10) de l'une quelconque des revendications 1 à 4,
au moins l'un du premier bras de serrage (30) et du second bras de serrage (40) comprenant une saillie (35),
ladite saillie (35) étant disposée au niveau de la même position que la première partie de contact (71C) et la seconde partie de contact (72B) dans une direction d'insertion (92) de l'objet de mesure (60) dans le capteur de serrage (10) lorsque l'objet de mesure (60) est serré par le premier bras de serrage (30) et le second bras de serrage (40), ou au niveau d'une position en amont de la première partie de contact (71C) et de la seconde partie de contact (72B) dans la direction d'insertion (92),
ladite saillie (35) comprise dans le premier bras de serrage (30) faisant saillie davantage vers la seconde partie de contact (72B) que vers la première partie de contact (71C) lorsqu'elle est vue à partir d'une direction de largeur (91) parallèle à l'axe de pivotement (51), et
ladite saillie (35) comprise dans le second bras de serrage (40) faisant saillie davantage vers la première partie de contact (71C) que vers la seconde partie de contact (72B) lorsqu'elle est vue à partir de la direction de largeur (91).

6. Capteur de serrage (10) de l'une quelconque des revendications 1 à 5,
ledit premier conducteur (71) et ledit second conducteur (72) possédant une fonction de blindage contre les ondes électromagnétiques pour l'objet de mesure (60) serré par le premier bras de serrage (30) et le second bras de serrage (40).

7. Capteur de serrage (10) de l'une quelconque des revendications 1 à 5,
ledit premier conducteur (71) et ledit second conducteur (72) étant des électrodes fonctionnant en tant qu'unités de mesure.

8. Capteur de serrage (10) de l'une quelconque des revendications 1 à 5,
ledit premier conducteur (71) comprenant :
un premier conducteur de blindage (30A) possédant une fonction de blindage contre les ondes électromagnétiques pour l'objet de mesure (60) serré par le premier bras de serrage (30) et le second bras de serrage (40) ; et
une première électrode fonctionnant en tant qu'unité de mesure,
ledit second conducteur (72) comprenant :
un second conducteur de blindage (40A) possédant une fonction de blindage contre les ondes électromagnétiques pour l'objet de mesure (60) serré par le premier bras de serrage (30) et le second bras de serrage (40) ; et
une seconde électrode fonctionnant en tant qu'unité de mesure,
chacun du premier conducteur de blindage (30A) et de la première électrode comprenant la première partie de contact (71C),
chacun du second conducteur de blindage (40A) et de la seconde électrode comprenant la seconde partie de contact (72B),
ladite première partie de contact (71C) du premier conducteur de blindage (30A) et ladite seconde partie de contact (72B) du second conducteur de blindage (40A) entrant en contact l'une avec l'autre et se séparant l'une de l'autre, et
ladite première partie de contact (71C) de la première électrode et ladite seconde partie de contact (72B) de la seconde électrode entrant en contact l'une avec l'autre et se séparant l'une de l'autre.

9. Capteur de serrage (10) de la revendication 8,
lorsqu'elles sont vues à partir d'une direction de largeur (91) parallèle à l'axe de pivotement (51), ladite première partie de contact (71C) du premier conducteur de blindage (30A) et ladite seconde partie de contact (72B) du second conducteur de blindage (40A) étant positionnées sur l'un d'un côté opposé à l'axe de pivotement (51) par rapport à une position de serrage au niveau de laquelle l'objet de mesure (60) est serré par le premier bras de serrage (30) et le second bras de serrage (40) et du côté de l'axe de pivotement (51) par rapport à la position de serrage, et
lorsqu'elles sont vues à partir de la direction de largeur (91), ladite première partie de contact (71C) de la première électrode et ladite seconde partie de contact (72B) de la seconde électrode étant positionnées de l'autre côté d'un côté opposé à l'axe de pivotement (51) par rapport à la position de serrage et du côté de l'axe de pivotement (51) par rapport à la position de serrage.
